# EUROPEAN PATENT APPLICATION

(11) **EP 4 614 551 A1**
(43) Date of publication of application: **10.09.2025**
(21) Application number: 24162270.3
(22) Date of filing: 08.03.2024
(51) Int. Cl.: H01L 21/48, H01L 23/15, H01L 23/373, H01L 23/62, H01L 23/498

(54) **SUBSTRATE AND METHOD FOR PRODUCING A SUBSTRATE**

(71) Applicant: Infineon Technologies AG, 85579 Neubiberg (DE)
(72) Inventor: BAYER, Christoph, 97776 Eußenheim (DE); GOLDAMMER, Martin, 59494 Soest (DE); KELLNER, Sebastian, 59590 Geseke (DE)
(74) Representative: Westphal, Mussgnug & Partner, Patentanwälte mbB

(57) **Abstract**

A method comprises forming a first sub-layer on a substrate, the substrate comprising a dielectric insulation layer, and a metallic layer permanently attached to a first surface of the dielectric insulation layer, wherein the first sub-layer partly covers a lateral surface of the metallic layer, and covers a section of the first surface of the dielectric insulation layer, wherein the lateral surface of the metallic layer is a surface extending perpendicular to the first surface of the dielectric insulation layer, after forming the first sub-layer, performing an intermediate step, and after performing the intermediate step, forming a second sub-layer on the substrate, wherein the second sub-layer covers the first sub-layer, and partly covers the lateral surface of the metallic layer.

## Description

### TECHNICAL FIELD

The instant disclosure relates to a substrate and a method for producing a substrate, in particular a substrate comprising a ceramic layer with at least one metallization layer attached thereto.

### BACKGROUND

Power semiconductor module arrangements often include at least one semiconductor substrate arranged in a housing. A semiconductor arrangement including a plurality of controllable semiconductor elements (e.g., two IGBTs in a half-bridge configuration) is arranged on each of the at least one substrate. Each substrate usually comprises a substrate layer (e.g., a ceramic layer), a first metallization layer deposited on a first side of the substrate layer and a second metallization layer deposited on a second side of the substrate layer. The controllable semiconductor elements are each mounted, for example, on the first metallization layer by means of an electrically conductive connection layer. During the use of the power semiconductor module arrangement, high electric field strengths may be present at the edges of the metallization layers that may cause unwanted breakthroughs. Further, the edges of the metallization layers may be exposed to high mechanical stress. This may result in damages at the edges of the metallization layers, the substrate layer, and the electrically conductive connection layers, or any other layers of the arrangement, for example, which may negatively affect the function of the power semiconductor module arrangement and significantly reduce its lifetime. The function of the power semiconductor module arrangement may further be negatively affected and its lifetime may be reduced due to unwanted corrosion effects or humidity that may be present in the power semiconductor module arrangement, which may damage, e.g., the metallization layers, the substrate layer, and the electrically conductive connection layers, if it comes into direct contact with the respective layers.

There is a need for a substrate and a method for producing a substrate which is less likely to get damaged and has an increased lifetime.

### SUMMARY

A method includes forming a first sub-layer on a substrate, the substrate including a dielectric insulation layer, and a metallic layer permanently attached to a first surface of the dielectric insulation layer, wherein the first sub-layer partly covers a lateral surface of the metallic layer, and covers a section of the first surface of the dielectric insulation layer, wherein the lateral surface of the metallic layer is a surface extending perpendicular to the first surface of the dielectric insulation layer, after forming the first sub-layer, performing an intermediate step, and after performing the intermediate step, forming a second sub-layer on the substrate, wherein the second sub-layer covers the first sub-layer, and partly covers the lateral surface of the metallic layer.

A substrate includes a dielectric insulation layer, a metallic layer permanently attached to a first surface of the dielectric insulation layer, and a passivation layer at least partly covering a lateral surface of the metallic layer, and covering a section of the dielectric insulation layer, wherein the lateral surface of the metallic layer is a surface extending perpendicular to the first surface of the dielectric insulation layer, wherein the passivation layer includes two or more sub-layers.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a power semiconductor module arrangement.
Figure 2 schematically illustrates a metallization layer on a dielectric insulation layer.
Figure 3, including Figures 3A to 3D, schematically illustrates a method for producing a substrate according to one example.
Figure 4, including Figures 4A and 4B, schematically illustrates a method for producing a substrate according to one example.
Figure 5 schematically illustrates a section of a substrate according to one example.
Figure 6 schematically illustrates a section of a substrate according to another example.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description, as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connecting pads and includes at least one semiconductor element with electrodes.

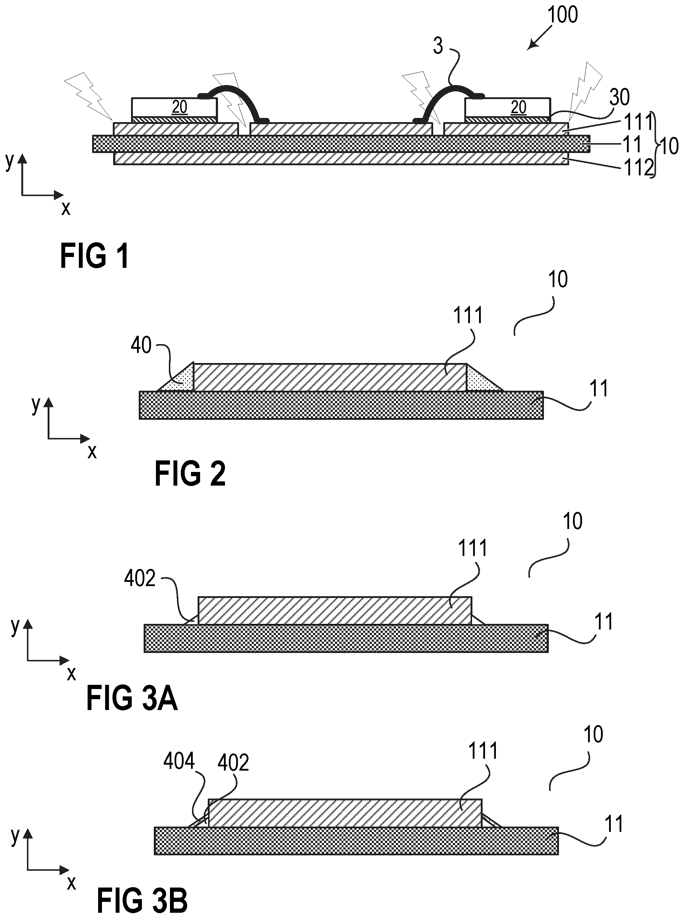

Referring to Figure 1, a cross-sectional view of a power semiconductor arrangement 100 is schematically illustrated. The power semiconductor arrangement 100 includes a substrate 10. The substrate 10 includes a dielectric insulation layer 11, a (structured) first metallization layer (metallic layer) 111 attached to the dielectric insulation layer 11, and a (structured) second metallization layer (metallic layer) 112 attached to the dielectric insulation layer 11. The dielectric insulation layer 11 is disposed between the first and second metallization layers 111, 112. The second metallization layer 112, however, is optional and can be omitted.

Each of the first and second metallization layers 111, 112 can consist of or include one of the following materials: copper; a copper alloy; aluminum; an aluminum alloy; any other metal or alloy that remains solid during the operation of the power semiconductor arrangement. The substrate 10 can be a ceramic substrate, that is, a substrate in which the dielectric insulation layer 11 is a ceramic, e.g., a thin ceramic layer. The ceramic can consist of or include one of the following materials: aluminum oxide; aluminum nitride; zirconium oxide; silicon nitride; boron nitride; or any other dielectric ceramic. For example, the dielectric insulation layer 11 can consist of or include one of the following materials: Al₂O₃, AIN, SiC, BeO or Si₃N₄. For instance, the substrate 10 may, e.g., be an Active Metal Brazing (AMB), or a Direct Copper Bonding (DCB) substrate.

The substrate 10 can be arranged in a housing (not specifically illustrated). One or more semiconductor bodies 20 can be arranged on the substrate 10. Each of the semiconductor bodies 20 arranged on the substrate 10 can include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable controllable semiconductor element.

The one or more semiconductor bodies 20 can form a semiconductor arrangement on the substrate 10. In Figure 1, only two semiconductor bodies 20 are exemplarily illustrated. The second metallization layer 112 of the substrate 10 in Figure 1 is a continuous layer. The first metallization layer 111 is a structured layer in the example illustrated in Figure 1. "Structured layer" means that the first metallization layer 111 is not a continuous layer, but includes recesses between different sections of the layer. Such recesses are schematically illustrated in Figure 1. The second metallization layer 112 can also be a structured layer or may be omitted altogether, for example. The first metallization layer 111 in this example includes three different sections. Different semiconductor bodies 20 can be mounted to the same or to different sections of the first metallization layer 111. Different sections of the first metallization layer can have no electrical connection or can be electrically connected to one or more other sections using, e.g., bonding wires 3. Electrical connections 3 can also include bonding ribbons, connection plates, connection clips, or conductor rails, for example, to name just a few examples. The one or more semiconductor bodies 20 can be electrically and mechanically connected to the substrate 10 by an electrically conductive connection layer 30. Such an electrically conductive connection layer can be a solder layer, a layer of an electrically conductive adhesive, or a layer of a sintered metal powder, e.g., a sintered silver powder, for example.

During the use of the power semiconductor module arrangement 100, high electric field strengths may be present especially at the edges of the different sections of the first metallization layer 111 which may cause unwanted breakthroughs. This is schematically illustrated by means of the flashes in Figure 1. Further, the edges of the metallization layers 111, 112 may be exposed to high mechanical stress. The metallization layers 111, 112, therefore, may get damaged especially at their edges which may negatively affect the function of the power semiconductor module arrangement 100 and significantly reduce its lifetime.

Now referring to Figure 2, a substrate 10 comprising a dielectric insulation layer 11 and a metallic layer 111 arranged on a first surface of the dielectric insulation layer 11 is schematically illustrated. As has been described with respect to Figure 1 above, the dielectric insulation layer 11 may be a ceramic layer. The dielectric insulation layer 11 can comprise or consist of Al₂O₃, AlN, SiC, BeO or Si₃N₄, for example. Other materials are also possible. The metallic layer 111 can consist of or include one of the following materials: copper; a copper alloy; aluminum; an aluminum alloy; any other metal or alloy that remains solid during the operation of the power semiconductor arrangement. In Figure 2, a second metallic layer is not illustrated. As has been described above, a second metallic layer is generally optional. However, the same principles that will be described with respect to the metallic layer 111 below, similarly apply to any other metallic layer arranged on the dielectric insulation layer 11. It is further noted that the general principles will be described with respect to a metallic layer 111 having only one section (continuous layer), but apply similarly to different sections of a structured metallic layer (see, e.g., first metallization layer 111 of Figure 1).

The substrate 10 illustrated in Figure 2 further comprises a passivation layer 40 at least partly covering a lateral surface of the metallic layer 111, and covering a section of the dielectric insulation layer 11. The lateral surface of the metallic layer 111 is a surface extending perpendicular (or essentially perpendicular) to the first surface of the dielectric insulation layer 11. In this way, the edges of the metallic layer 111 are passivated and are protected by the passivation layer 40 during the subsequent use of the power semiconductor module arrangement. There is a risk, however, that cavities form in a passivation layer 40, e.g., when curing/hardening the passivation layer 40, when heating the passivation layer 40, or when storing the substrate 10 comprising the passivation layer 40, for example. This is, because gasses may be present in the material forming the passivation layer 40. Outgassing may occur, for example, in the metallic layer 111 and/or the dielectric insulation layer 11. That is, gasses escaping from the metallic layer 111 and/or the dielectric insulation layer 11 may pass into the passivation layer 40 which adjoins the metallic layer 111 and the dielectric insulation layer 11. Such gasses may subsequently not evaporate from the passivation layer 40, but may be enclosed ("trapped") in the material of the passivation layer 40, thereby forming unwanted cavities. Such cavities in the passivation layer 40 may reduce its efficiency and may subsequently lead to failures of a power semiconductor module 100 in which the substrate 10 is included.

Now referring to Figures 3A and 3B, a method according to embodiments of the disclosure will be described with which a passivation layer 40 may be formed that has less or even no cavities formed in its material. The method comprises forming a first sub-layer 402 on a substrate 10, the substrate 10 comprising a dielectric insulation layer 11, and a metallic layer 111 permanently attached to a first surface of the dielectric insulation layer 11. The first sub-layer 402 partly covers a lateral surface of the metallic layer 111, and covers a section of the first surface of the dielectric insulation layer 11. The lateral surface of the metallic layer 111 is a surface extending perpendicular to the first surface of the dielectric insulation layer 11. After forming the first sub-layer 402, an intermediate step is performed, and, after performing the intermediate step, a second sub-layer 404 is formed on the substrate 10, wherein the second sub-layer 404 covers the first sub-layer 402, and partly covers the lateral surface of the metallic layer 111. That is, a stack of two sub-layers 402, 404 is formed. This stack of two (thin) sub-layers 402, 404 forms the (thicker) passivation layer 40.

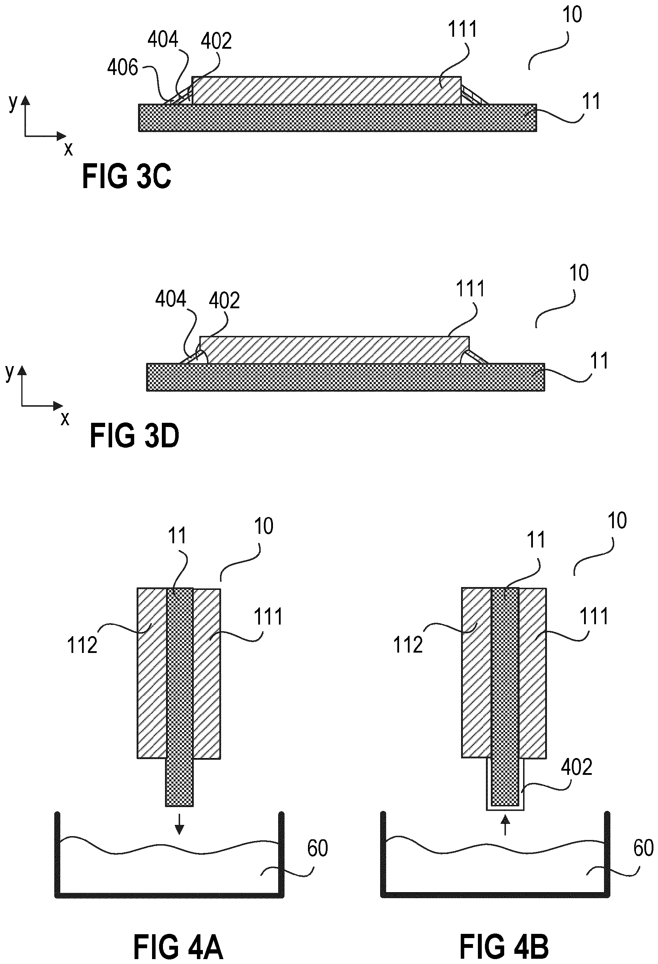

A passivation layer 40 comprising two sub-layers 402, 404, however, is only an example. A passivation layer 40 may comprise even more than two sub-layers 402, 404. Referring to Figure 3C, after forming the second sub-layer 404, at least one further sub-layer 406 may be formed. Any further sub-layers may follow (not specifically illustrated). An intermediate step is performed after forming the second and any further sub-layer 404, 406. Each of the sub-layers 402, 404, 406 is thin as compared to the resulting passivation layer 40. Performing an intermediate step may comprise at least one of waiting for a defined period of time (e.g., between 10 seconds and 60 minutes), heating the respective sub-layer 402, 404, 406, and curing and/or hardening the respective sub-layer 402, 404, 406. According to one example, the respective sub-layer 402, 404, 406 may be irradiated with ultraviolet (UV) light. Any components of the respective sub-layer 402, 404, 406 that remain uncured after an intermediate step may be removed before forming a subsequent sub-layer on top. During an intermediate step, any gasses that are present in the respective sub-layer 402, 404, 406 may escape from the respective sub-layer 402, 404, 406. This is possible, as the sub-layers 402, 404, 406 are thin as compared to the resulting passivation layer 40.

While Figs. 3A-3C show the lateral surfaces of the metallic layer 111 to be perfectly flat surfaces meeting the dielectric insulation layer 11 at perfect right angles, in reality these lateral surfaces are often irregular. In particular, the lateral surface may be formed such that there is a concavity where the metallic layer 111 meets the dielectric insulation layer 11, as schematically shown in Fig. 3D. In this case, at least the first sub-layer 402 will fill the concavity as illustrated, so as to fully protect the interface between the metallic layer 111 and the dielectric insulation layer 11. It is also contemplated that subsequent sub-layers 404, 406 might fill the cavity as well, depending on the size of the concavity and the thicknesses of the sub-layers 402, 404, 406.

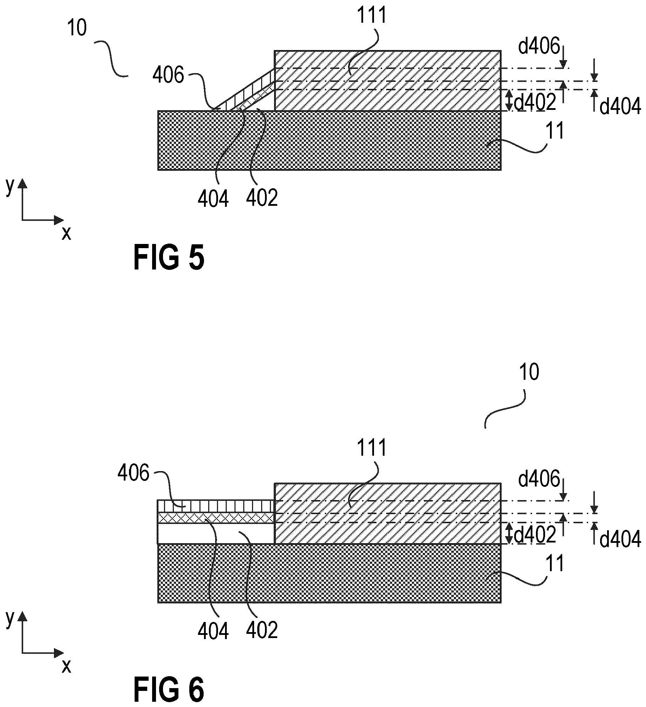

At least the first sub-layer 402 which is closest to the metallic layer 111 may have a maximum thickness d402 of between 2 and 5µm, for example. A (maximum) thickness of a sub-layer may be defined as its thickness in a vertical direction y perpendicular to the first surface of the dielectric insulation layer 11. The sub-layers 402, 404, 406 may have an essentially triangular cross-section, as is schematically illustrated in Figures 2, 3 and 5, for example. As is schematically illustrated in Figure 6, however, other cross-sections are also possible. The specific shape of a sub-layer and the resulting cross-section may depend on the process that is used for its formation.

As is schematically illustrated in Figures 4A and 4B, for example, a sub-layer 402 may be formed by means of a dip coating method. Figure 4A schematically illustrates a substrate 10 before forming a sub-layer thereon. The substrate 10 may be immersed ("dipped") into a liquid material 60. While the substrate 10 remains in the coating material 60, a thin layer of material forms on its surface. When the substrate 10 is pulled out of the material 60, a sub-layer 402 has formed thereon and remains on the substrate 10. As mentioned above, an intermediate step follows during which any gasses present in the sub-layer 402 may evaporate. Forming a sub-layer by means of dip coating, however, is only an example. Alternatively, a sub-layer may be formed by applying material by means of a spray coating method, by applying material by means of a powder coating process, by applying material by means of a thermal spaying method, by applying material by means of a plasma coating process, or by applying material by means of a dispensing method, for example.

According to one example, the first sub-layer 402 is formed as a thin sub-layer, e.g., having a maximum thickness d402 of between 2 and 5µm. In this way, gasses resulting from an outgassing of the metallic layer 111 and/or the dielectric insulation layer 11 are able to entirely pass through the thin first sub-layer 402. By the end of the intermediate step and before forming the second sub-layer 404, no or almost no gasses remain in the first sub-layer 402. The second sub-layer 404 may have the same or a greater thickness d404 than the first sub-layer 402. Outgassing from the metallic layer 111 and/or the dielectric insulation layer 11 mainly occurs while forming the first sub-layer 402 or during the subsequent intermediate step. No significant further outgassing may be expected when forming the second sub-layer 404. However, even if further outgassing occurred, the first sub-layer 402 would act as a barrier such that gasses could not reach the second sub-layer 404 through the first sub-layer 402. Therefore, no cavities may form in the second sub-layer 404, irrespective of a maximum thickness d404 of the second sub-layer 404.

According to one example, therefore, a passivation layer 40 may comprise a comparably thin first sub-layer 402 having a maximum thickness d402 of, e.g., between 2 and 5µm, and a comparably thick second sub-layer 404 having a maximum thickness d404 of, e.g., between 10µm and 70µm, or between 30µm and 70µm. According to other examples, a passivation layer 40 may comprise three or more sub-layers 402, 404, 406. Different sub-layers 402, 404, 406 may have the same or may have different maximum thicknesses d402, d404, d406. A certain thickness of the resulting passivation layer 40 may be required in order for the passivation layer 40 to be able to effectively passivate the edges of the metallic layer 111. For example, a maximum thickness of the resulting passivation layer 40 may be between 50% and 100% of a thickness of the metallic layer 111 in the same direction. That is, the passivation layer 40 may cover between 50% and 100% of the respective lateral surface of the metallic layer 111.

Each of the sub-layers 402, 404, 406 may comprise or consist of a polymer, for example. It is generally possible, that each of the different sub-layers 402, 404, 406 comprises or consists of the same polymer. According to one example, however, each of the sub-layers 402, 404, 406 comprises or consists of a different polymer. Polymers are generally dielectrically insulating and are well suited for forming passivation layers 40 for a substrate 10. Further, polymers usually sufficiently adhere to the metallic layer 111 as well as to the dielectric insulation layer 11. However, one or more preconditioning steps may be performed before forming the first sub-layer 402. For example, an atmospheric plasma treatment may be performed on the substrate 10. Other additional or alternative pretreatment steps include atmospheric plasma treatment with subsequent lowering of a surface energy on the lateral surface of the metallic layer 111, low pressure plasma treatment, washing, coating, primer application, atomic layer deposition, tempering, laser treatment, CO₂ cleaning, etc. Pretreating the respective surfaces of the metallic layer 111 and/or the dielectric insulation layer 11 may increase the adhesion of the first sub-layer 402 on the respective surfaces. The respective surfaces may be smoothed or polished, cleaned, activated and/or wetted by means of one or more pretreatment steps.

The resulting passivation layer 40 is dielectrically insulating. Therefore, at least one of the two or more sub-layers 402, 404, 406 is dielectrically insulating. According to one example, each sub-layer of the two or more sub-layers 402, 404, 406 is dielectrically insulating. It is, however, also possible that one or more, but not all, of the sub-layers 402, 404, 406 are electrically conducting. For example, the first sub-layer 402 may comprise or consist of an electrically conducting material, while any following sub-layers 404, 406 are dielectrically insulating. It is, however, also possible that the first sub-layer 402 is dielectrically insulating, and one or more of the following sub-layers 404, 406 comprise or consist of an electrically conducting material.

In the examples illustrated in the Figures and described above, the passivation layer 40 only partly covers the respective lateral surfaces of the metallic layer 111. It is, however, also possible that the passivation layer 40 entirely covers the respective lateral surfaces of the metallic layer 111. It is even possible that the passivation layer 40 also partly covers a top surface of the metallic layer 111 close to its edges. Further, in the examples illustrated in the Figures and described above, outer edges of a metallic layer 111 are passivated, wherein the outer edges of a metallic layer are edges that face towards an edge of the dielectric insulation layer 11. It is, however, also possible that trenches between two adjacent sections of a structured metallic layer 111 be filled and thereby passivated by means of the two or more sub-layers 402, 404, 406. In this way, a dielectric strength within the respective trenches may be increased.

## Claims

1. A method comprises:
forming a first sub-layer (402) on a substrate (10), the substrate (10) comprising a dielectric insulation layer (11), and a metallic layer (111) permanently attached to a first surface of the dielectric insulation layer (11), wherein the first sub-layer (402) partly covers a lateral surface of the metallic layer (111), and covers a section of the first surface of the dielectric insulation layer (11), wherein the lateral surface of the metallic layer (111) is a surface extending perpendicular to the first surface of the dielectric insulation layer (11);
after forming the first sub-layer (402), performing an intermediate step; and
after performing the intermediate step, forming a second sub-layer (404) on the substrate (10), wherein the second sub-layer (404) covers the first sub-layer (402), and partly covers the lateral surface of the metallic layer (111).

2. The method of claim 1, wherein performing an intermediate step comprises at least one of:
waiting for a defined period of time;
heating the first sub-layer (402); and
curing and/or hardening the first sub-layer (402).

3. The method of claim 1 or 2, wherein the first sub-layer (402) is formed having a maximum thickness (d402) of between 2 and 5µm.

4. The method of any of claims 1 to 3, further comprising
after forming the second sub-layer (404), forming at least one further sub-layer (406), wherein an intermediate step is performed after forming the second and any further sub-layer (404, 406).

5. The method of any of claims 1 to 4, wherein forming a sub-layer (402, 404, 406) comprises one of:
applying material by means of a spray coating method;
applying material by means of a dip coating method;
applying material by means of a powder coating process;
applying material by means of a thermal spaying method;
applying material by means of a plasma coating process; and
applying material by means of a dispensing method.

6. The method of any of the preceding claims, wherein each of the sub-layers (402, 404, 406) comprises or consists of a polymer.

7. The method of claim 6, wherein each of the sub-layers (402, 404, 406) comprises or consists of a different polymer.

8. The method of any of the preceding claims, wherein at least one of
the metallic layer (111) comprises or consists of copper, a copper alloy, aluminum, or an aluminum alloy; and
the dielectric insulation layer (11) comprises or consists of Al₂O₃, AlN, SiC, BeO or Si₃N₄.

9. A substrate (10) comprising:
a dielectric insulation layer (11);
a metallic layer (111) permanently attached to a first surface of the dielectric insulation layer (11); and
a passivation layer (40) at least partly covering a lateral surface of the metallic layer (111), and covering a section of the dielectric insulation layer (11), wherein the lateral surface of the metallic layer (111) is a surface extending perpendicular to the first surface of the dielectric insulation layer (11), wherein
the passivation layer (40) comprises two or more sub-layers (402, 404, 406).

10. The substrate (10) of claim 9, wherein the dielectric insulation layer comprises or consists of Al₂O₃, AlN, SiC, BeO or Si₃N₄.

11. The substrate (10) of claim 9 or 10, wherein the at least one metallic layer (111) consist of or includes one of the following materials: copper; a copper alloy; aluminum; and an aluminum alloy.

12. The substrate (10) of any of claims 9 to 11, wherein each of the two or more sub-layers (402, 404, 406) of the passivation layer (40) comprises or consists of a polymer.

13. The substrate (10) of claim 12, wherein each of the sub-layers (402, 404, 406) of the passivation layer (40) comprises or consists of a different polymer.

14. The substrate (10) of any of claims 9 to 13, wherein at least one of the sub-layers (402, 404, 406) of the passivation layer (40) has a maximum thickness (d402, d404, d406) of between 2 and 5µm.

15. The substrate (10) of any of claims 9 to 14, wherein the passivation layer (40) covers between 50% and 100% of the respective lateral surface of the metallic layer (111).

## Amended claims

### Amended claims in accordance with Rule 137(2) EPC.

1. A method comprises:
forming a first sub-layer (402) on a substrate (10), the substrate (10) comprising a dielectric insulation layer (11), and a metallic layer (111) permanently attached to a first surface of the dielectric insulation layer (11), wherein the first sub-layer (402) partly covers a lateral surface of the metallic layer (111), and covers a section of the first surface of the dielectric insulation layer (11), wherein the lateral surface of the metallic layer (111) is a surface extending perpendicular to the first surface of the dielectric insulation layer (11);
after forming the first sub-layer (402), performing an intermediate step; and
after performing the intermediate step, forming a second sub-layer (404) on the substrate (10), wherein the second sub-layer (404) covers the first sub-layer (402), and partly covers the lateral surface of the metallic layer (111),
wherein the first sub-layer (402) is formed having a maximum thickness (d402) of between 2 and 5µm.

2. The method of claim 1, wherein performing an intermediate step comprises at least one of:
waiting for a defined period of time;
heating the first sub-layer (402); and
curing and/or hardening the first sub-layer (402).

3. The method of claim 1 or 2, further comprising
after forming the second sub-layer (404), forming at least one further sub-layer (406), wherein an intermediate step is performed after forming the second and any further sub-layer (404, 406).

4. The method of any of claims 1 to 3, wherein forming a sub-layer (402, 404, 406) comprises one of:
applying material by means of a spray coating method;
applying material by means of a dip coating method;
applying material by means of a powder coating process;
applying material by means of a thermal spaying method;
applying material by means of a plasma coating process; and
applying material by means of a dispensing method.

5. The method of any of the preceding claims, wherein each of the sub-layers (402, 404, 406) comprises or consists of a polymer.

6. The method of claim 5, wherein each of the sub-layers (402, 404, 406) comprises or consists of a different polymer.

7. The method of any of the preceding claims, wherein at least one of
the metallic layer (111) comprises or consists of copper, a copper alloy, aluminum, or an aluminum alloy; and
the dielectric insulation layer (11) comprises or consists of Al₂O₃, AlN, SiC, BeO or Si₃N₄.

8. A substrate (10) comprising:
a dielectric insulation layer (11);
a metallic layer (111) permanently attached to a first surface of the dielectric insulation layer (11); and
a passivation layer (40) at least partly covering a lateral surface of the metallic layer (111), and covering a section of the dielectric insulation layer (11), wherein the lateral surface of the metallic layer (111) is a surface extending perpendicular to the first surface of the dielectric insulation layer (11), wherein
the passivation layer (40) comprises two or more sub-layers (402, 404, 406), and
at least one of the sub-layers (402, 404, 406) of the passivation layer (40) has a maximum thickness (d402, d404, d406) of between 2 and 5µm.

9. The substrate (10) of claim 8, wherein the dielectric insulation layer comprises or consists of Al₂O₃, AlN, SiC, BeO or Si₃N₄.

10. The substrate (10) of claim 8 or 9, wherein the at least one metallic layer (111) consist of or includes one of the following materials: copper; a copper alloy; aluminum; and an aluminum alloy.

11. The substrate (10) of any of claims 8 to 10, wherein each of the two or more sub-layers (402, 404, 406) of the passivation layer (40) comprises or consists of a polymer.

12. The substrate (10) of claim 11, wherein each of the sub-layers (402, 404, 406) of the passivation layer (40) comprises or consists of a different polymer.

13. The substrate (10) of any of claims 8 to 12, wherein the passivation layer (40) covers between 50% and 100% of the respective lateral surface of the metallic layer (111).
